# EUROPÄISCHE PATENTSCHRIFT

(11) **EP 3 427 313 B1**
(45) Veröffentlichungstag und Bekanntmachung des Hinweises auf die Patenterteilung: **15.11.2023**
(21) Anmeldenummer: 17709957.9
(22) Anmeldetag: 09.03.2017
(51) Int. Cl.: H10K 71/40, H10K 71/80, H10K 10/46

(54) **VERFAHREN ZUR HERSTELLUNG EINER HALBLEITENDEN FOLIE UND ELEKTRONISCHES BAUELEMENT**
METHOD FOR THE PRODUCTION OF A SEMICONDUCTING FILM, AND ELECTRONIC COMPONENT
PROCÉDÉ DE FABRICATION D'UN FILM SEMI-CONDUCTEUR ET COMPOSANT ÉLECTRONIQUE

(30) Priorität: 09.03.2016 DE 102016104254
(43) Veröffentlichungstag der Anmeldung: 16.01.2019
(73) Patentinhaber: Friedrich-Schiller-Universität Jena, 07743 Jena (DE)
(72) Erfinder: TURCHANIN, Andrey, 07747 Jena (DE); NICKEL, Bert, 85737 Ismaning (DE)
(74) Vertreter: Harrison, Robert John
(86) Internationale Anmeldenummer: PCT/EP2017/055547
(87) Internationale Veröffentlichungsnummer: WO 2017/153524

(56) Entgegenhaltungen:
- ANDREY TURCHANIN ET AL: "One Nanometer Thin Carbon Nanosheets with Tunable Conductivity and Stiffness", ADVANCED MATERIALS, Bd. 21, Nr. 12, 26. März 2009 (2009-03-26) , Seiten 1233-1237, XP055236242, DE ISSN: 0935-9648, DOI: 10.1002/adma.200803078 & ANDREY TURCHANIN ET AL: "Supporting Information: One Nanometer Thin Carbon Nanosheets with Tunable Conductivity and Stiffness", ADVANCED MATERIALS, Bd. 21, Nr. 12, 26. März 2009 (2009-03-26) , Seiten 1233-1237, XP055377771, DE ISSN: 0935-9648, DOI: 10.1002/adma.200803078
- R.A.M. HIKMET ET AL: "Electron-Beam-Induced Crosslinking of Electroluminescent Polymers for the Production of Multi-Color Patterned Devices", ADVANCED MATERIALS, Bd. 15, Nr. 2, 16. Januar 2003 (2003-01-16), Seiten 115-117, XP055377450, DE ISSN: 0935-9648, DOI: 10.1002/adma.200390021
- VIRKAR A ET AL: "Oligothiophene based organic semiconductors with cross-linkable benzophenone moieties", SYNTHETIC METALS, ELSEVIER SEQUOIA, LAUSANNE, CH, Bd. 158, Nr. 21-24, 5. August 2008 (2008-08-05), Seiten 958-963, XP025804239, ISSN: 0379-6779, DOI: 10.1016/J.SYNTHMET.2008.06.019 [gefunden am 2008-08-05]
- J. SAYAGO ET AL: "Low voltage electrolyte-gated organic transistors making use of high surface area activated carbon gate electrodes", JOURNAL OF MATERIALS CHEMISTRY C: MATERIALS FOR OPTICAL AND ELECTRONIC DEVICES, Bd. 2, Nr. 28, 2. Juni 2014 (2014-06-02), Seite 5690, XP055381080, UK ISSN: 2050-7526, DOI: 10.1039/c4tc00864b

## Beschreibung

### Beschreibung

Die Erfindung betrifft ein Verfahren zur Herstellung einer organischen halbleitenden Folie sowie ein daraus hergestelltes elektronisches Bauelement.

Organische Halbleiter sind Halbleiter, die auf organischen Materialien basieren und in elektronischen Bauelementen, wie z.B. Transistoren, Leuchtdioden und Solarzellen, verwendet werden. Beispiele solche Halbleiter sind konjugierte Moleküle wie
- linear kondensierte Ringsysteme (z. B. Oligoacene wie Anthracen, Pentacen und dessen Derivate (z. B. Chinacridon oder Pentachinone), oder auch z. B. Benzenthiolate)
- lineare Ringsysteme mit Stickstoff (z.B. Diazapentacene)
- lineare Ringsysteme mit Schwefel (z.B. Sexithiophene (6T), Dinaphthothienothiophene (DNTT))
- wasserstoffbrückenbildenden Pigmente (z.B. Indigo, Chinacridon) und deren Derivate und lösliche Varianten (z.B. alkalisierte) oder auch z. B. Bcnzcnthiolate),
- zweidimensional kondensierte Ringsysteme (z.B. Perylen, PTCDA und dessen Derivate, Naphthalin-Derivate, Hexabenzocoronen)
- Metallkomplexe (z. B. Phthalocyanine, oder Alq3, Beq2)
- dendritische Moleküle, Starburst-Moleküle (z. B. 4,4',4"-tris(N,N-diphenyl-amino) triphenylamine (TDATA)); und heterozyklische Oligomere (z. B. Oligothiophene, Oligophenylenevinylene).

Ein häufig eingesetztes, organisches Material für eine dünne Schicht in organischen Halbleiter-Bauelementen (auch organische Elektronik genannt) ist Pentacen. Dieses Material ist ein polyzyklischer aromatischer Kohlenwasserstoff mit fünf linear kondensierten Benzolringen und hat eine sehr hohe Löcherbeweglichkeit bis 5,5 cm²/(Vs) bei der Anwendung in einem organischen Feldeffekttransistor (FET).

Aus dem Stand der Technik sind verschiedene Verfahren zur Herstellung von halbleitenden Folien bekannt. Zum Beispiel offenbart Turchanin et al. "One Nanometer Thin Carbon Nanosheets with Tunable Conductivity and Stiffness", ADVANCED MATERIALS, Bd. 21, Nr. 12, 26. März 2009, Seiten 1233-1237, XP055236242, DE ISSN: 0935-9648, DOI: 10.1002/adma.200803078 ein Verfahren zur Herstellung einer organischen, isolierenden Folie umfassend eine Beschichtung eines Trägersubstrats mit einer Opferschicht, gefolgt von einem Aufbringen eines Films aus einem organischen Material auf ein Trägersubstrat zur Vernetzung des organischen Material und eine Bestrahlung der Oberfläche des aufgebrachten Films mit einem Niedrigenergie-Elektronenstrahl (100eV). Das Verfahren umfasst ferner eine Ablösung des bestrahlten Films von dem Trägersubstrat.

Hikmet et al.: "Electron-Beam-Induced Crosslinking of Electroluminescent Polymers for the Production of Multi-Color Patterned Devices", ADVANCED MATERIALS, Bd. 15, Nr. 2, 16. Januar 2003, Seiten 115-117, XP055377450, ISSN: 0935-9648, DOI: 10.1002/adma.200390021 beschreibt ein Verfahren zur Herstellung einer organischen, halbleitenden Folie umfassend ein Aufbringen eines Films aus einem organischen Material auf ein Trägersubstrat und Bestrahlung der Oberfläche des Films mit einem Niedrigenergie-Elektronenstrahl zur Vernetzung des organischen Materials.

Virkar et AL: "Oligothiophene based organic semiconductors with cross-linkable benzophenone moieties", SYNTHETIC METALS, ELSEVIER SEQUOIA, LAUSANNE, CH, Bd. 158, Nr. 21-24, 5. August 2008, Seiten 958-963, XP025804239, ISSN: 0379-6779, DOI: 10.1016/J.SYNTHMET.2008.06.019 beschreibt ein Halbleiterbauelement mit einer halbleitenden organischen Schicht aus Oligothiphene mit einem vernetzten obersten Teil.

Die bisher in der organischen Elektronik verwendeten, dünnen Schichten weisen allerdings einige Nachteile auf. Zum Beispiel sind einige der Moleküle, aus denen die dünnen Schichten durch Aufdampfen hergestellt sind, nur schlecht oder gar nicht löslich. Die aufgedampften Schichten sind van der Waals-Kristalle und daher nicht sehr stabil. Als Ergebnis ist eine Bearbeitung (Prozessieren) der aufgedämpften dünnen Schichten mit gängigen Photolacken problematisch, da die aufgedämpften dünnen Schichten nicht ausreichend stabil genug für nasschemische und lösungsmittelbasierte Verarbeitungsschritte sind. Bei aufeinanderfolgenden Aufdampfschritten kann es zu einer unkontrollierten Vermischung der Schichten durch Diffusionsprozesse in den Schichten kommen. Darüber hinaus ist die Wachstumstemperatur sehr eingeschränkt, und bestimmte Oberflächen der Schichten werden nicht gut von einem darauf wachsenden Film benetzt, was zu einem schlechten elektrischen Kontaktwiderstand zwischen den Schichten führt.

Es besteht daher Bedarf an einer organischen halbleitenden Folie, die prozessierbar ist und in einem elektronischen Bauelement z.B. einem FET eingesetzt werden kann.

Diese Aufgabe wird mit Hilfe eines Verfahrens zur Herstellung einer organischen, halbleitenden Folie nach Anspruch 1 gelöst, wobei das Verfahren folgende Schritte umfasst: Beschichtung eines Trägersubstrats mit einer Opferschicht, wobei die Opferschicht ein wasserlöslicher Film ist, gefolgt von einem Aufbringen eines Films aus einem organischen Material auf das Trägersubstrat, und danach eine Bestrahlung der Oberfläche des Films. Die Bestrahlung der Oberfläche erfolgt durch niederenergetische Elektronen in einem Niedrigenergie-Elektronstrahl. Die Bestrahlung führt auf Grund der niedrigen Energie der Elektronen zu einer Vernetzung des obersten Teils der halbleitenden Schicht, d.h. nur in dem oberflächennahen Bereich der halbleitenden, organischen Schicht. Die Tiefe des oberflächennahen Bereichs hängt von der Energie der niederenergetischen Elektronen ab. Das Trägersubtrat kann ein festes Substrat sein, wie zum Beispiel ein Metall, ein Polymer, ein anorganischer Halbleiter oder ein Isolator.

Durch diese Vernetzung ist die Schicht wesentlich stabiler und kann besser manipuliert werden. Die Vernetzung des obersten Teils der Schicht lässt den unteren Teil der Schicht unberührt, da die Elektronen lediglich eine geringe Eindringtiefe haben. Der untere Teil der Schicht verliert somit die halbleitenden Eigenschaften nicht.

Die vernetzte Oberfläche der halbleitenden, organischen Schicht macht auch die hergestellte Folie stabil gegenüber der Umgebung, da die vernetzte Oberfläche eine Art "Schutzschicht" bildet. Die vernetzte Oberfläche gibt der Folie eine hohe mechanische Stabilität, was grundsätzlich auch eine Verwendung als freistehende Schichten ermöglicht. In einem solchen Fall sind beide Oberflächen der Folie frei zugänglich und daher für die Anwendung in der Sensorik geeignet.

Die Bestrahlung kann den oberen Teil der Schicht in ein Dielektrikum umwandeln. Bei geeigneter Dosierung und Energie kann somit ein Gate-Isolator für einen Feldeffekttransistor gebildet werden. Diese Transistoren werden u.a. in Elektrolyten mit einer kleinen angelegten Spannung als Sensor betrieben.

In einem weiteren Schritt wird die bestrahlte Schicht von dem Trägersubstrat abgelöst. Diese Ablösung ermöglicht ein Aufbringen der Schicht auf ein anderes Substrat, z.B. aus einem Polymer, Glas, Silizium, Siliziumoxid, einer Legierung wie Messing oder einem Metall wie Gold oder Aluminium, auf dem die halbleitende, organische Schicht sonst nicht oder nur schlecht wachsen würde. Nach Trocknung in einer Niedervakuum-Umgebung und bei Raumtemperatur ist die Haftung zwischen der halbleitenden, organischen Schicht und dem anderen Substrat sehr stark.

Die mit Hilfe dieses Verfahrens hergestellten Folien können in einem elektronischen Bauelement verwendet werden. Ein nicht limitierendes Beispiel ist ein Feldeffekttransistor.

Weitere Eigenschaften und Vorteile der Erfindung ergeben sich aus der folgenden, rein beispielhaften und in keiner Weise beschränkenden Beschreibung bevorzugter Ausführungsformen und Aspekten der Erfindung unter Bezugnahme auf die beigefügten Zeichnungen, darin zeigen:
Fig. 1 den Ablauf des Herstellungsverfahrens für eine halbleitende, organische Folie.
Fig. 2 eine Skizze der Herstellung der Folie aus einem Film.
Fig. 3A und 3B zwei Aspekte eines Feldeffekttransistors aus der Folie.

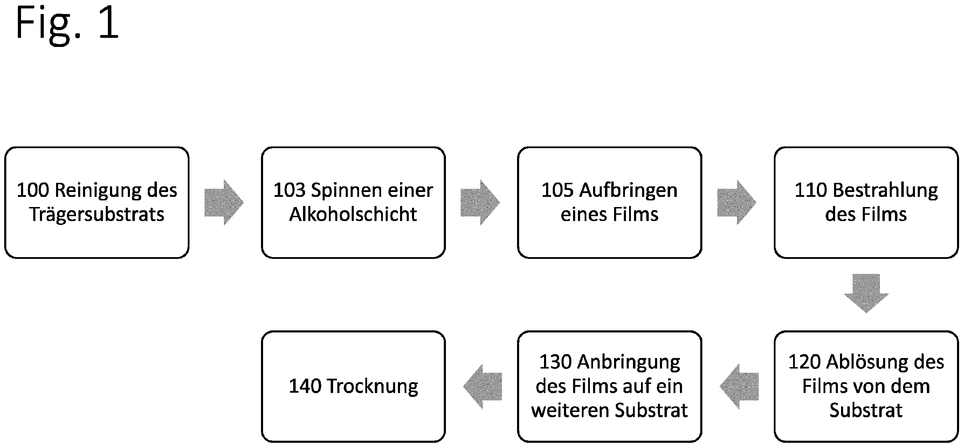

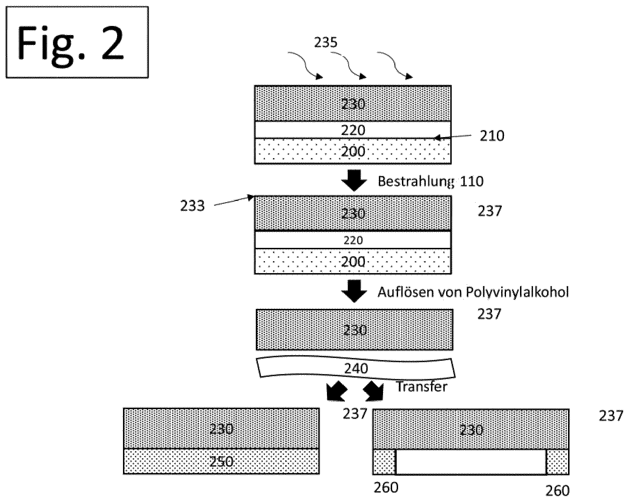

Fig. 1 zeigt den Ablauf des Herstellungsverfahrens und Fig. 2 zeigt eine Übersicht der Herstellungsschritte. In einem ersten ersten Schritt 100 wird ein Trägersubstrat 200 gereinigt. Im Schritt 103 wird eine Opferschicht 220 aus einem wasserlöslichen Film aus Alkohol oder einem Polymer auf der Oberfläche 210 des Trägersubstrates 200 aufgeschleudert. Der Alkohol kann z.B. Polyvinylalkohol oder eine andere Art Polyvinyl mit Alkohol-Seitengruppen sein.

Auf der Opferschicht 220 wird im Schritt 105 ein Film 230 aus einem halbleitenden Material durch z.B. Dünnschicht-Verdampfung ("thin film vapour deposition") in einer Knudsen-Zelle aufgebracht. Dieser aufgebrachte Film 230 hat eine Dicke z.B. zwischen 50 und 100 nm. In einem nicht-limitierenden Aspekt der Erfindung ist der Film 230 aus Pentacen. Die Oberfläche 233 des aufgebrachten Films 230 wird durch einen Niedrigenergie-Elektronstrahl 235 im Schritt 110 bestrahlt. Diese Bestrahlung 235 bewirkt eine Vernetzung des obersten Teils 237 des aufgebrachten Films 230. Die Bestrahlung 100, 235 findet bei einer Energie zwischen 10 und 10.000 eV und bei einer Dosis von 1 bis 100 mC/cm² statt. Die Tiefe des vernetzten obersten Teils 237 hängt von der Energie der Elektronen ab. Bei einer Bestrahlung mit einer Energie von 800 eV hat der vernetzte oberste Teil 237 eine Tiefe von ca. fünf Monoschichten, d.h. ca. 7,5 nm. Bei einer Energie von 300 eV ist die Tiefe drei Monoschichten, d.h. ca. 4,5 nm. Im Allgemeinen sind Tiefen von 5 bis 80 nm möglich.

In dem folgenden Schritt 120 kann das Trägersubstrat 200 mit dem aufgebrachten Film 230 in eine wässrige Flüssigkeit z.B. deionisiertem Wasser 240 eingetaucht werden. Aufgrund der Opferschicht 220 aus wasserlöslichem Alkohol trennt sich der aufgebrachte Film 230 von dem Trägersubstrat 200 und schwimmt in der Form von "Folien" auf der Oberfläche der Flüssigkeit. Die Folien können auch in der Flüssigkeit schweben. Diese Folien können mit Hilfe einer Pinzette auf ein weiteres Substrat 250 im Schritt 130 angebracht werden und im Schritt 140 in einem Niedervakuum bei Raumtemperatur getrocknet werden. Bei großflächigen Folien ist ein automatisiertes Gerät zum Transfer der Folien aus der Flüssigkeit oder durch ein Roll-to-Roll-Verfahren auf das weitere Substrat 250 denkbar.

Beispiele für weitere Substrate 250 umfassen z.B. Messing, Gold, Aluminium, Glass, Silizium, Siliziumdioxid, und Polymere.

### Beispiel

Das Trägersubstrat 200 aus Silizium und Siliziumdioxid wurde zunächst in einem Ultraschall-Bad in Aceton und Isopropylalkohol jeweils für 10 Minuten beschallt. Danach wurde das Trägersubstrat 200 in deionisiertem Wasser gespült und die Oberfläche 210 mit Hilfe eines Plasmas (LabAsh) für 30s gereinigt.

Die Lösung zur Herstellung der Opferschicht 220 aus wasserlöslichen Alkohol wurde durch das folgende Protokoll hergestellt. Zunächst wurde eine 5% Lösung von Polyvinylalkohol (Fluka Polyvinylalkohol 6-98) in deionisiertem Wasser durch Rühren um 800 Drehung je Minuten bei 75°C über 3 Stunden hergestellt. Danach wurde die Lösung filtriert.

Die so hergestellte Lösung wurde auf die gereinigte Oberfläche 210 des Trägersubstrats 200 bei 4000 Drehungen/Minute für 60s aufgeschleudert und bildet die Opferschickt 220. Die Opferschicht (wasserlösliche Schicht) 220 hat somit eine Dicke von ca. 200 nm.

Das Aufbringen des Films 230 erfolgt durch Aufdampfen von Pentacen (Sigma Aldrich dreifach sublimiert, mit weiterer Reinigung durch Creaphys) bei einer Rate von ca. 0,1 Ås⁻¹ bei Raumtemperatur und einen Druck in der Kammer unter 10⁻⁷ millibar. Der Elektronstrahl 235 zur Vernetzung der Oberfläche 233 des aufgebrachten Films 230 stammt von einem Perkin Eimer Niedrigenergie-Elektronenbeugung-System (PHI Model 11-020). Der Emissionsstrom wurde bei 5 mA gehalten. In zwei Beispielen wurde Elektronstrahlung mit jeweils einer Energie von 300 eV bzw. 800 eV für eine Minute mit einer Dosierung von ungefähr 3,0 mC/cm² verwendet. Die Zeit für die Bestrahlung hängt von der verwendeten Kanone ab.

Nach Vernetzung des obersten Teils des Films 230 wird das Trägersubstrat 200 mit dem Film 230 in einem Wasserbad zur Ablösung des Films eingetaucht und die entstandene Folie auf das weitere Substrat 250 (Fig. 2, linke Seite) oder auf Trägerelemente 260 als freistehende Film 230 (Fig. 2, rechte Seite) durch ein Transfer-Verfahren aufgebracht. Die Trägerelemente 260 sind zum Beispiel durch ein poröses weiteres Substrat 250 gebildet.

### Verwendung der Folie

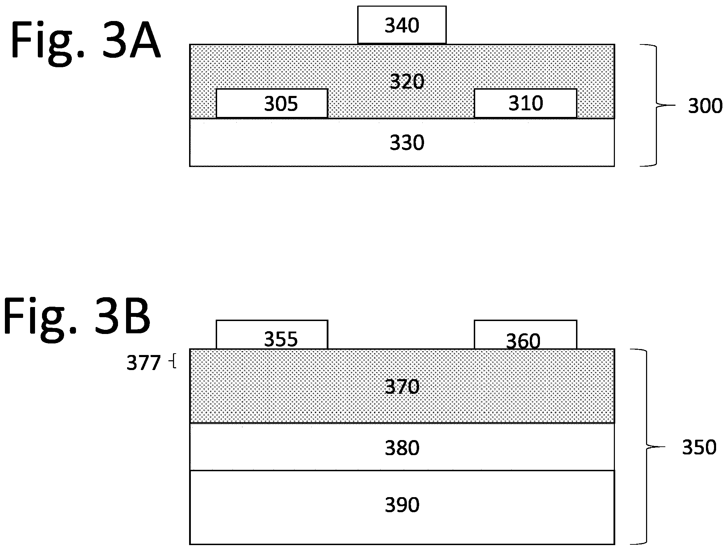

Fig. 3A und 3B zeigen die exemplarische Verwendung der Folie 230 in einem Feldeffekttransistor 300. Die Folie 230 entsteht durch Trennen bzw. Ablösen des Films von dem Trägersubstrat 200.

Fig. 3A zeigt einen Feldeffekttransistor 300 mit sogenannten Bottom-Kontakten für eine Source-Elektrode 305 und eine Drain-Elektrode 310 auf einer Isolatorschicht 330. Die Source-Elektrode 305 und die Drain-Elektrode 310 sind z.B. aus Gold und auf der Isolatorschicht 330 aufgedampft. In diesem Aspekt der Erfindung ist eine Halbleiterschicht 320 mit einer Dicke von ca. 50 nm auf der Oberfläche der Isolatorschicht 380 (Parylene oder Siliziumdioxid) und auch auf der Source-Elektrode 355 und der Drain-Elektrode 360 durch Transfer aufgebracht. Eine Gate-Elektrode 340 ist auf der Oberfläche der Halbleiterschicht 320 z.B. durch Aufdampfen von Gold aufgebracht. Diese Gate-Elektrode 340 könnte auch ein Elektrolyt sein. In diesem Fall wird die vernetzte Schicht 377 als ein Gate-Dielektrikum verwendet.

Fig. 3B zeigt einen Feldeffekttransistor 350 mit sogenannten Top-Kontakten für die Source-Elektrode 355 und die Drain-Elektrode 360. Diese Halbleiterschicht 370 hat eine Dicke von z.B. 50 nm und ist auf der Isolatorschicht 380 aufgebracht. Die Isolatorschicht 380 ist z.B. eine 1000 nm dicke Schicht von Parylene oder eine 100 nm dicke Schicht von Siliziumdioxid. In diesem Fall ist die Gate-Elektrode 390 ist auf der unteren Seite der Isolatorschicht 330 aufgebracht. Die Gate-Elektrode 340 ist z.B. aus Aluminium, Siliziumdioxid oder Gold.

### Bezugszeichen

- 200: Trägersubstrat
- 210: Oberfläche
- 220: Opferschicht
- 230: Aufgedampfter Film
- 233: Oberfläche
- 235: Bestrahlung
- 237: Oberstes Teil
- 240: Bad
- 250: Weiteres Substrat
- 260: Trägerelement
- 300: Feldeffekttransistor
- 305: Source-Elektrode
- 310: Drain-Elektrode
- 320: Halbleiterschicht
- 330: Isolatorschicht
- 340: Gate-Elektrode
- 350: Feldeffekttransistor
- 355: Source-Elektrode
- 360: Drain-Elektrode
- 370: Halbleiterschicht
- 377: Vernetztes Teil
- 380: Isolatorschicht
- 390: Gate-Elektrode

## Patentansprüche

1. Verfahren zur Herstellung einer organischen, halbleitenden Folie umfassend:
Beschichtung (103) eines Trägersubstrats (200) mit einer Opferschicht (220), wobei die Opferschicht ein wasserlöslicher Film (220) ist;
gefolgt von einem Aufbringen (103) eines Films (230) aus einem organischen Material auf das Trägersubstrat (200);
Bestrahlung der Oberfläche (233) des Films (230) mit einem Niedrigenergie-Elektronenstrahl zur Vernetzung des oberflächennahen Bereichs des organischen Materials, wobei der Niedrigenergie-Elektronenstrahl eine Elektronstrahl-Energie zwischen 10 eV und 10,000 eV aufweist; und
Ablösung (120) des bestrahlten Films (230) von dem Trägersubstrat (200).

2. Verfahren nach Anspruch 1, wobei die Ablösung (120) durch Abtauchen des bestrahlten Films (230) auf dem Trägersubstrat (200) in eine Flüssigkeit (220), z.B. Wasser, erfolgt.

3. Verfahren nach einem der Ansprüche 1 bis 2, weiter umfassend
Anbringen (130) des abgelösten Films (230) auf ein weiteres Substrat (250).

4. Verfahren nach einem der vorhergehenden Ansprüche, wobei das organische Material ausgewählt ist aus der Gruppe von halbleitenden Materialien bestehend aus linear kondensierten Ringsystemen, lineare Ringsysteme mit Stickstoff oder mit Schwefel, wasserstoffbrückenbildenden Pigmente, zweidimensional kondensierte Ringsysteme, Metallkomplexe, dendritische Moleküle, Starburst-Moleküle, und heterozyklische Oligomere.

5. Verfahren nach einem der vorhergehenden Ansprüchen, wobei das organische Material Pentacen, Anthracen, Chinacridon, Pentachinone, Benzenthiolat, Sexithiophene (6T), Dinaphthothienothiophene (DNTT), Indigo, Chinacridon, Perylen, PTCDA, Naphthalin-Derivate, Hexabenzocoronen, Phthalocyanine, Alq3, Beq2, 4,4',4"-tris(N,N-diphenyl-amino), triphenylamine (TDATA), Oligothiophene oder Oligophenylenevinylene sowie Derivate dieser organischen Materialien ist.

6. Verfahren nach einem der vorhergehenden Ansprüche, wobei das Trägersubstrat (200) ein festes Substrat z.B. aus Polymer, Metallen, Legierungen, Glas, Silizium, Siliziumdioxid, Siliziumcarbid oder Siliziumnitrid ist.

7. Verfahren nach einem der Ansprüche 4 bis 6, wobei das weitere Substrat (250) aus Polymeren, Metallen, Legierungen, Glas Silizium, Siliziumdioxid, Siliziumcarbid oder Siliziumnitrid ist.

8. Verfahren nach Ansprüche 4 bis 7, wobei das weitere Substrat (250) ein poröses Substrat ist und der abgelöste Film auf dem weiteren Substrat (250) freistehend ist.

9. Halbleitende organische Folie (230) aus einem organischen Material, wobei nur der oberflächennahe oberste Teil (237) vernetzt ist, und wobei das organische Material Pentacen, Anthracen, Chinacridon, Pentachinone, Benzenthiolat, Sexithiophene (6T), Dinaphthothienothiophene (DNTT), Indigo, Chinacridon, Perylen, PTCDA, Naphthalin-Derivate, Hexabenzocoronen, Phthalocyanine, Alq3, Beq2, 4,4',4"-tris(N,N-diphenyl-amino), triphenylamine (TDATA), Oligothiophene oder Oligophenylenevinylene sowie Derivate dieser organischen Materialien ist.

10. Halbleitende organische Folie (230) nach Anspruch 9, wobei die halbleitende organische Folie (230) freistehend zwischen Trägerelementen (260) angeordnet ist.

11. Verwendung einer halbleitenden organischen Folie (230) nach einem der Ansprüche 9 oder 10 in einer halbleitenden organischen Schicht (320, 370) eines Halbleiterbauelements.

12. Verwendung nach Anspruch 11, wobei die halbleitende organische Schicht (320) zwei Elektroden (305, 310) auf einer Seite hat und eine Gate-Elektrode (340) auf der gegenüberliegenden Seite aufweist.

13. Verwendung nach Anspruch 12, wobei die Gate-Elektrode (340) ein Elektrolyt ist.

14. Verwendung nach Anspruch 11, wobei die halbleitende organische Schicht (370) zwei Elektroden (355, 360) bedeckt.

15. Verwendung nach einem der Ansprüche 12 bis 14, wobei die zwei Elektroden (305, 310; 355, 360) auf einer Isolatorschicht (330, 350) aufgebracht sind.

## Claims

1. A method for production of an organic semiconducting film comprising:
coating (103) a support substrate (200) with a sacrificial layer (220), wherein the sacrificial layer is a water-soluble film (220);
followed by application (103) of a film (230) of an organic material on the support substrate (200);
irradiation of the surface (233) of the film (230) with a low-energy electron beam to crosslink the near-surface region of the organic material, the low-energy electron beam having an electron beam energy between 10 eV and 10,000 eV; and
detachment (120) the irradiated film (230) from the support substrate (200).

2. The method according to claim 1, wherein the detachment (120) is performed by immersing the irradiated film (230) on the support substrate (200) into a liquid (220), e.g. water.

3. The method according to any one of claims 1 to 2, further comprising:
attaching (130) the detached film (230) on a further substrate (250).

4. The method according to any one of the preceding claims, wherein the organic material is selected from the group of semiconducting materials consisting of linear condensed ring systems, linear ring systems with nitrogen or with sulfur, hydrogen bridging pigments, two-dimensional condensed ring systems, metal complexes, dendritic molecules, starburst molecules, and heterocyclic oligomers.

5. The method of any one of the preceding claims, wherein the organic material is pentacene, anthracene, quinacridone, pentachinone, benzenethiolate, sexithiophene (6T), dinaphthothienothiophene (DNTT), indigo, quinacridone, perylene, PTCDA, naphthalene derivatives, hexabenzocorone, phthalocyanine, Alq3, Beq2, 4,4',4"-tris(N,N-diphenyl-amino), triphenylamine (TDATA), oligothiophene, or oligophenylenevinylene, and derivatives of these organic materials.

6. The method according to any one of the preceding claims, wherein the support substrate (200) is a solid substrate of, for example, polymer, metals, alloys, glass, silicon, silicon dioxide, silicon carbide, or silicon nitride.

7. The method according to any one of claims 4 to 6, wherein the further substrate (250) is made of polymers, metals, alloys, glass silicon, silicon dioxide, silicon carbide, or silicon nitride.

8. The method according to claims 4 to 7, wherein the further substrate (250) is a porous substrate, and the detached film is free standing on the further substrate (250).

9. A semiconducting organic film (230) made of an organic material, wherein only the near-surface uppermost portion (237) is crosslinked, and wherein the organic material is pentacene, anthracene, quinacridone, pentachinone, benzenthiolate, sexithiophene (6T), dinaphthothienothiophene (DNTT), indigo, quinacridone, perylene, PTCDA, naphthalene derivatives, hexabenzocoron, phthalocyanine, Alq3, Beq2, 4,4',4"-tris(N,N-diphenyl-amino), triphenylamine (TDATA), oligothiophene, or oligophenylenevinylene, and derivatives of these organic materials.

10. The semiconducting organic film (230) according to claim 9, wherein the semiconducting organic film (230) is free standing between support elements (260).

11. Use of a semiconducting organic film (230) according to one of claims 9 or 10 in a semiconducting organic layer (320, 370) of a semiconductor component.

12. The use according to claim 11, wherein the semiconducting organic layer (320) has two electrodes (305, 310) on one side and a gate electrode (340) on the opposite side.

13. The use according to claim 12, wherein the gate electrode (340) is an electrolyte.

14. The use according to claim 11, wherein the semiconducting organic layer (370) covers two electrodes (355, 360).

15. The use according to any one of claims 12 to 14, wherein the two electrodes (305, 310; 355, 360) are deposited on an insulator layer (330, 350).

## Revendications

1. Procédé de fabrication d'un film organique semi-conducteur comprenant :
revêtement (103) d'un substrat de support (200) avec une couche sacrificielle (220), dans lequel la couche sacrificielle est un film soluble dans l'eau (220) ;
suivi d'une application (103) d'un film (230) d'un matériau organique sur le substrat de support (200) ;
irradiation de la surface (233) du film (230) avec un faisceau d'électrons de faible énergie pour réticuler la région proche de la surface du matériau organique, le faisceau d'électrons de faible énergie ayant une énergie de faisceau d'électrons comprise entre 10 eV et 10 000 eV; et
détachement (120) du film irradié (230) du substrat de support (200).

2. Procédé selon la revendication 1, dans lequel le détachement (120) est effectué par immersion du film irradié (230) sur le substrat de support (200) dans un liquide (220), par exemple de l'eau.

3. Procédé selon l'une quelconque des revendications 1 à 2, comprenant en outre l'application (130) du film détaché (230) sur un autre substrat (250).

4. Procédé selon l'une quelconque des revendications précédentes, dans lequel le matériau organique est choisi dans le groupe des matériaux semi-conducteurs constitué par les systèmes cycliques linéaires condensés, les systèmes cycliques linéaires avec de l'azote ou du soufre, les pigments formant des ponts hydrogène, les systèmes cycliques condensés bidimensionnels, complexes métalliques, molécules dendritiques, molécules en étoile et oligomères hétérocycliques.

5. Procédé selon l'une quelconque des revendications précédentes, dans lequel la matière organique est du pentacène, de l'anthracène, de la quinacridone, du pentaquinone, du benzènethiolate, du sexitiophène (6T), du dinaphtothiénothiophène (DNTT), de l'indigo, de la quinacridone, du pérylène, du PTCDA, des dérivés de naphtalène, de l'hexabenzocorone, de la phtalocyanine, de l'Alq3, du Beq2, du 4,4',4"-tris(N,N-diphényl-amino), de la triphénylamine (TDATA), de l'oligothiophène ou l'oligophénylènevinylène, ainsi que les dérivés de ces matières organiques.

6. Procédé selon l'une quelconque des revendications précédentes, dans lequel le substrat de support (200) est un substrat solide, par exemple en polymère, métaux, alliages, verre, silicium, silice, carbure de silicium ou nitrure de silicium.

7. Procédé selon l'une quelconque des revendications 4 à 6, dans lequel l'autre substrat (250) est en polymères, métaux, alliages, verre, silicium, dioxyde de silicium, carbure de silicium ou nitrure de silicium.

8. Procédé selon les revendications 4 à 7, dans lequel l'autre substrat (250) est un substrat poreux et le film détaché est autoportant sur l'autre substrat (250).

9. Film organique semi-conducteur (230) constitué d'un matériau organique, dans lequel seule la partie supérieure (237) proche de la surface est réticulée, et dans lequel le matériau organique comprend du pentacène, de l'anthracène, de la quinacridone, du pentachinone, du benzenethiolate, du sexithiophène (6T), du dinaphthothi-énothiophène (DNTT), de l'indigo, de la quinacridone, du pérylène, du PTCDA, des dérivés de naphtalène, de l'hexabenzocorone, de la phtalocyanine, de l'Alq3, du Beq2, du 4,4',4"-tris(N,N-diphényl-amino), de la triphenylamine (TDATA), de l' oligothiophène ou L'oligophénylènevinylène, ainsi que les dérivés de ces matières organiques.

10. Film organique semi-conducteur (230) selon la revendication 9, dans lequel le film organique semi-conducteur (230) est disposé de manière autoportante entre des éléments de support (260).

11. Utilisation d'un film organique semi-conducteur (230) selon l'une quelconque des revendications 9 ou 10 dans une couche organique semi-conductrice (320, 370) d'un dispositif semi-conducteur.

12. Utilisation selon la revendication 11, dans laquelle la couche organique semi-conductrice (320) comprend deux électrodes (305, 310) sur une face et une électrode de grille (340) sur la face opposée.

13. Utilisation selon la revendication 12, dans laquelle l'électrode de grille (340) est un électrolyte.

14. Utilisation selon la revendication 11, dans laquelle la couche organique semi-conductrice (370) recouvre deux électrodes (355, 360).

15. Utilisation selon l'une quelconque des revendications 12 à 14, dans laquelle les deux électrodes (305, 310 ; 355, 360) sont déposées sur une couche isolante (330, 350).
